Europäisches Patentamt

European Patent Office

Office européen des brevets

(19)

(11) **EP 1 030 182 A1**

(12) ## DEMANDE DE BREVET EUROPEEN

(43) Date de publication:
**23.08.2000 Bulletin 2000/34**

(51) Int Cl.$^7$: **G01R 1/067**

(21) Numéro de dépôt: **00430006.7**

(22) Date de dépôt: **15.02.2000**

(84) Etats contractants désignés:
**AT BE CH CY DE DK ES FI FR GB GR IE IT LI LU
MC NL PT SE**
Etats d'extension désignés:
**AL LT LV MK RO SI**

(30) Priorité: **18.02.1999 FR 9902198**

(71) Demandeur: **STMicroelectronics
94250 Gentilly Cedex (FR)**

(72) Inventeurs:
• **Smears, Nicholas
38120 Saint Egreve (FR)**
• **Nayler, Peter
38100 Grenoble (FR)**
• **Planelle, Philippe
38700 La Tronche (FR)**

(74) Mandataire: **Marchand, André
OMNIPAT,
24 Place des Martyrs de la Résistance
13100 Aix-en-Provence (FR)**

(54) **Procédé d'étalonnage d'une sonde de circuit integré RF**

(57) L'invention concerne un procédé d'étalonnage d'une sonde (20) de circuit intégré RF, comprenant une étape de détermination des caractéristiques des lignes de transmission RF de la sonde (20) au moyen d'un analyseur de réseau (90) et de circuits étalons (60, 70) sur substrat de silicium (75), les circuits étalons comprenant des plages de contact correspondant par leur agencement à des plages de connexion RF de circuits intégrés à tester.

FIG.15

EP 1 030 182 A1

**Description**

La présente invention concerne le test électrique de circuits intégrés dits "RF", comportant des entrées ou des sorties prévues pour recevoir ou délivrer des signaux alternatifs dans le domaine des radiofréquences.

La présente invention concerne plus particulièrement le test électrique des circuits intégrés RF présents sur une plaquette de silicium, communément appelée "wafer", avant la découpe de la plaquette en composants individuels.

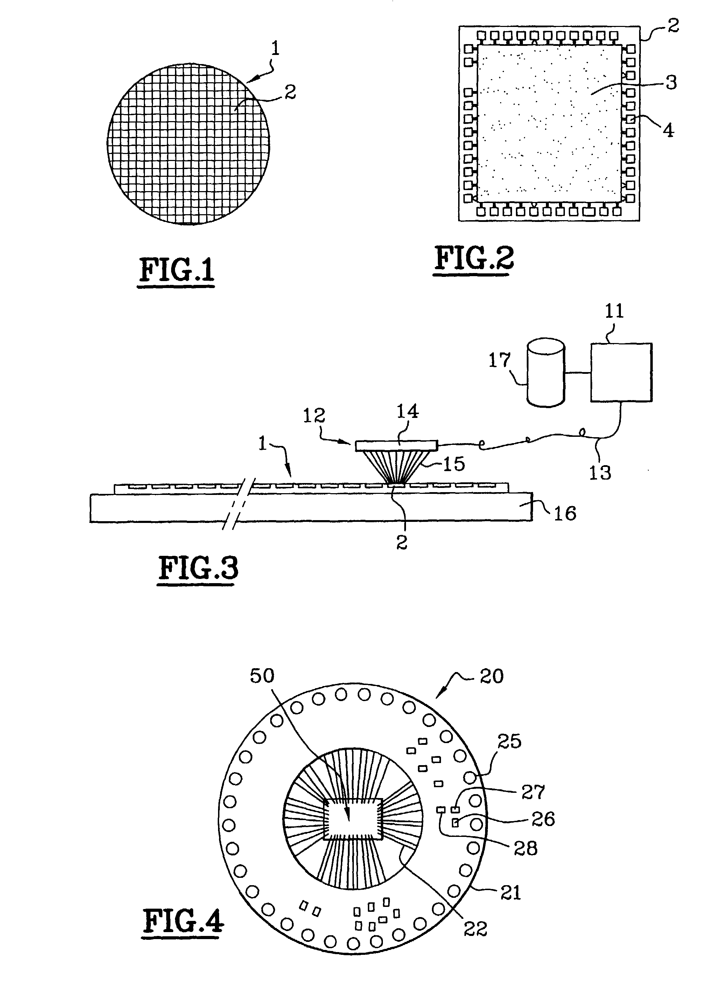

Pour fixer les idées, la figure 1 représente un wafer de silicium 1 sur lequel a été réalisé, par photolithographie, un grand nombre de circuits intégrés 2 de même structure. Sur la vue agrandie de la figure 2, il apparaît qu'un circuit intégré 2 présente une zone active 3 et des plages de connexion 4 reliées électriquement à la zone active 3. Un plus fort grossissement de la zone active 3 ferait apparaître des centaines voire des milliers de composants intégrés formant ensemble diverses fonctions électroniques devant être testées.

Les rendements de fabrication des circuits intégrés étant inférieurs à 100%, le test électrique des circuits intégrés 2 encore présents sur le wafer 1 permet d'identifier et de rejeter les circuits intégrés défectueux ou ceux qui ne présentent pas les caractéristiques attendues, avant la découpe du wafer et le montage des circuits intégrés individualisés dans un boîtier ou leur assemblage sur un support d'interconnexion. Cette opération est donc essentielle pour la diminution des coûts de production, notamment dans le cadre d'une production de masse.

La figure 3 représente très schématiquement un système classique de test de circuits intégrés sur wafer, comprenant une station de test 11 reliée à une sonde 12 par l'intermédiaire d'un faisceau de câbles électriques 13. La sonde 12 est une carte à circuit imprimé 14 pourvue de pointes métalliques 15 agencées pour coïncider avec les plages de connexion d'un circuit intégré 2. Le wafer 1 est disposé sur un plateau 16 mobile dans le plan horizontal et les circuits intégrés sont testés les uns après les autres, par des déplacements et des mouvements de levée et de descente du plateau 16. L'ensemble du système est piloté par un programme de test chargé dans une mémoire 17, qui détermine les caractéristiques électriques des signaux de test à appliquer aux circuits intégrés et les mesures à effectuer.

Ce procédé de test classique de circuits intégrés au moyen d'une sonde constituée par une carte à pointes, d'un emploi généralisé dans l'industrie, trouve ses limites lorsque l'on veut tester des circuits intégrés RF comportant des entrées/sorties RF nécessitant des fréquences de mesure allant de quelques centaines de MégaHertz à quelques GigaHertz. Il s'agit notamment des circuits intégrés comportant des fonctions analogiques de modulation et démodulation, des mélangeurs, des amplificateurs, des filtres, des oscillateurs contrôlés en tension (VCO), des boucles à verrouillage de phase (PLL)..., destinés aux récepteurs de radio, de télévision, aux radiotéléphones mobiles, aux récepteurs GPS... Dans ce domaine de fréquence, les signaux électriques ont des longueurs d'ondes courtes et l'on voit apparaître dans la sonde 12 et dans les conducteurs 13 reliant la sonde à la station de test 11 divers phénomènes de réflexion et de rotation de phase qui faussent les mesures électriques en créant des interférences et des changements de niveaux électriques. De plus, à haute fréquence, les pistes de cuivre de la carte à circuit imprimé 14 et les pointes 15 de la sonde 12 présentent des capacités et des inductances parasites non négligeables.

Pour pallier ces inconvénients, des sociétés spécialisées ont développé des sondes RF offrant des caractéristiques satisfaisantes à haute fréquence. Notamment, la société Cascade™ Microtech, sise Oregon 97005, USA, propose des pointes RF ("transmission line probes") de référence "Air Coplanar" et des sondes à membrane ("RFIC membrane probe cards") pourvues de conducteurs HF à microbandes ("microstrip") et de boules de contact en Nickel ("contact bumps"). De telles sondes offrent une bande passante de plusieurs dizaines de GigaHertz, un faible coefficient de réflexion S11 et un coefficient de transmission S12 d'une atténuation inférieure à 3dB (Cf. présentation des produits Cascade™ sur http//www.cmicro.com).

Parallèlement, les fabricants d'appareils de mesure comme la société Teradyne™ ont développé des stations de test (série A580) comportant des ports RF équipés d'un analyseur de réseau intégré ("vector network analyzer"), capable de déterminer les paramètres "S" (S11, S12/S21 et S22) d'une sonde par la méthode OSL ("Open, Short, Load"). Comme cela est bien connu de l'homme de l'art, la méthode OSL consiste à réaliser trois mesures en appliquant successivement à la sortie de la sonde au moins trois charges étalons, en général une impédance infinie (circuit ouvert), une impédance nulle (court-circuit), une impédance de 50Ω (charge). A partir de ces trois mesures, qui sont conservées dans la mémoire de l'appareil, l'analyseur de réseau détermine les paramètres "S" de la sonde et la station de test réalise, au cours de mesures ultérieures, une correction d'erreur automatique visant à compenser l'influence de ces paramètres pour l'obtention de mesures précises et fiables. A l'heure actuelle, les charges étalons utilisées sont des circuits couches minces sur substrat de céramique, calibrés par un laboratoire national de métrologie.

La demanderesse est toutefois arrivée à la constatation que ces divers moyens de test électrique de circuits intégrés RF ne permettent pas de mettre en oeuvre un procédé de test "en ligne", c'est-à-dire sur les lieux mêmes de production, qui soit réellement satisfaisant.

D'une part, les pointes RF du type "Air Coplanar" nécessitent un réglage manuel de l'orientation de pointes et demeurent réservées à des mesures de laboratoire ou à des petites productions. Les sondes à membrane pourvues de boules de contact, bien que spécialement conçues pour le test de circuits intégrés sur wafer, nécessitent pour être étalonnées l'emploi de circuits étalons à couches minces spécifiques d'un prix de revient élevé. Pour diverses autres raisons pratiques, la demanderesse considère que les sondes à membranes ne conviennent pas à une production de masse de circuits intégrés pouvant représenter plusieurs millions de pièces.

D'autre part, à chaque étalonnage, les pointes ou boules de contact des sondes sont appliquées avec force sur les plages de connexion des circuits étalons, de manière à briser une couche superficielle d'oxyde se formant au contact de l'air et établir un bon contact électrique ("soudure froide"). Les circuits étalons à couches minces, outre leur prix élevé, sont donc sujets à l'usure et ont une faible durée de vie.

Enfin, les circuits étalons à couches minces ne présentent pas la même épaisseur que les wafers de silicium et nécessitent pour leur installation un réglage du plateau 16 (figure 3) nécessairement suivi d'un autre réglage du plateau au moment de l'installation du wafer. Cet inconvénient se cumule avec le fait que les sondes RF nécessitent plusieurs étalonnages pendant le test d'un lot de puces. Ces divers étalonnages impliquent l'intervention d'un ingénieur qualifié et représentent 5 à 10% du temps consacré au test électrique.

Ainsi, un objectif général de la présente invention est de prévoir un procédé d'étalonnage d'une sonde RF qui soit adapté à une production de masse, économique, simple à mettre en oeuvre tout en étant précis et fiable, et qui puisse le cas échéant être mis en oeuvre par un personnel non qualifié.

Un objectif plus particulier de la présente invention est de prévoir un circuit étalon qui soit d'un faible prix de revient et simplifie l'étalonnage d'une sonde de circuit intégré RF.

Ces objectifs sont atteints par la prévision d'un procédé d'étalonnage d'une sonde de circuit intégré RF, comprenant une étape de détermination au moyen d'un analyseur de réseau et de circuits étalons des caractéristiques des lignes de transmission RF de la sonde, procédé dans lequel l'étape de détermination est réalisée au moyen de circuits étalons présents sur une plaquette de silicium, les circuits étalons comprenant des plages de contact correspondant par leur agencement à des plages de connexion RF du circuit intégré à tester et se différenciant entre eux par des impédances caractéristiques différentes mesurables depuis leurs plages de contact.

Selon un mode de réalisation, le procédé comprend une étape préalable de mesure des valeurs des impédances caractéristiques de circuits étalons, réalisée au moyen d'un matériel de mesure préalablement étalonné au moyen de charges de référence calibrées par un laboratoire agréé. Les valeurs des impédances caractéristiques des circuits étalons peuvent être fournies à l'analyseur de réseau par l'intermédiaire d'un support d'enregistrement de données. Elles peuvent également être lues dans des mémoires de type rémanent agencées dans les circuits étalons et accessibles en lecture ou en écriture par l'intermédiaire de plages de contact des circuits étalons, correspondant à des plages de connexion non-RF du circuit intégré à tester.

De préférence, l'étalonnage de la sonde est réalisé au moyen d'un premier circuit étalon comportant des plages de contact non connectées entre elles, d'un second circuit étalon comportant des plages de contact en court-circuit, et d'un troisième circuit étalon comportant des plages de contact reliées par des résistances électriques. L'étalonnage de la sonde peut par ailleurs être vérifié au moyen d'au moins un quatrième circuit étalon comportant des plages de contact reliées par des capacités ou des inductances.

Selon l'invention, la plaquette de silicium ne comporte que des circuits étalons ou comporte des circuits intégrés RF à tester et des circuits étalons en lieu et place de certains circuits intégrés RF.

Selon un mode de réalisation, les circuits étalons comprennent des structures étalons élémentaires comportant au moins deux plages de contact déposées sur une couche électriquement isolante, un écran conducteur enterré sous la couche isolante et les plages de contact surplombant l'écran conducteur.

Les structures étalons élémentaires peuvent comprendre deux charges étalons en série connectées par leur point milieu à l'écran conducteur, et au moins une plage de masse virtuelle pour la mesure des impédances de chaque charge étalon.

La présente invention concerne également un procédé de test électrique d'un circuit intégré RF présent sur une plaquette de silicium, comprenant une étape d'étalonnage de la sonde conforme au procédé décrit ci-dessus, les caractéristiques RF de la sonde étant utilisées comme termes correctifs au cours du test électrique du circuit intégré.

Selon un mode de réalisation, la sonde comprend une carte à circuit imprimé pourvue de pointes de contact de faible longueur. Des lignes de transmission RF de la sonde peuvent comprendre des condensateurs et des bobines pour compenser au moins en partie l'influence de capacités et d'inductances parasites.

Ces objets, caractéristiques et avantages de la présente invention ainsi que d'autres seront exposés plus en détail dans la description suivante du procédé de l'invention et de divers exemples de réalisation de structures et de circuits étalons selon l'invention, en relation avec les figures jointes parmi lesquelles :

- la figure 1 précédemment décrite représente une plaquette ou "wafer" de silicium comprenant des circuits intégrés,
- la figure 2 représente un circuit intégré présent sur le wafer de la figure 1,
- la figure 3 représente un système de test classique de circuit intégré non-RF,
- la figure 4 est une vue de dessus d'une sonde de circuit intégré RF selon l'invention,
- la figure 5 est une vue en coupe de la sonde selon l'invention,

- les figures 6 et 7 sont des schémas électriques de lignes de transmission RF de la sonde selon l'invention,
- la figure 8 illustre une modélisation sous forme de réseau RF d'une ligne de transmission RF,
- la figure 9A représente un circuit intégré RF et les figures 9B et 9C représentent deux circuits étalons selon l'invention,
- les figures 10 et 11 représentent des wafer de silicium comportant des circuits étalons selon l'invention,
- les figures 12, 13, 14 et 15 illustrent un procédé d'étalonnage selon l'invention d'une sonde de test RF,
- les figures 16A et 17A sont des vues en coupe de deux structures étalons élémentaires et illustrent un aspect de l'invention,
- les figures 16B et 17B sont des schémas électriques des structures étalons des figures 16A et 17A,
- les figures 18, 19, 20, 22 et 23 représentent par des vues de dessus divers modes de réalisation de structures étalons élémentaires selon l'invention, et
- la figure 21 est une vue en coupe de la structure étalon de la figure 20.

Comme mentionné au préambule, l'objectif général de l'invention est de réaliser le test électrique de circuits intégrés RF sur wafer de silicium dans un environnement industriel, d'une façon simple, rapide et peu coûteuse tout en obtenant des mesures précises et fiables. La présente invention comprend divers aspects qui seront décrits chacun indépendamment de l'autre.

**Réalisation d'une sonde RF à faible coût**

Selon un aspect de l'invention illustré par la figure 4, le test électrique de circuits intégrés RF est effectué au moyen d'une sonde 20 comprenant un circuit imprimé 21 pourvu de pointes métalliques 22. Le circuit imprimé est en forme d'anneau et les pointes 22, orientées vers le centre de la structure, sont agencées de manière à coïncider avec les plages de connexion d'un circuit intégré 50. La sonde 20 s'apparente par sa structure aux sondes classiques à circuit imprimé mais comporte des lignes de transmission RF offrant des caractéristiques satisfaisantes à haute fréquence. Comme on le verra plus loin, ces caractéristiques seront mesurées sous forme de paramètres "S" et compensées par les techniques classiques de correction d'erreur. La sonde 20 constitue ainsi une alternative aux sondes HF à membrane, optionnelle mais avantageuse en termes de souplesse d'emploi et de prix de revient, pour des fréquences de mesure se situant dans le bas du domaine RF, allant de quelques centaines de Mégahertz à quelques GigaHertz. La plupart des circuits intégrés RF actuels fonctionnant dans cette gamme de fréquences, la sonde 20 permet de couvrir la quasi-totalité des besoins industriels.

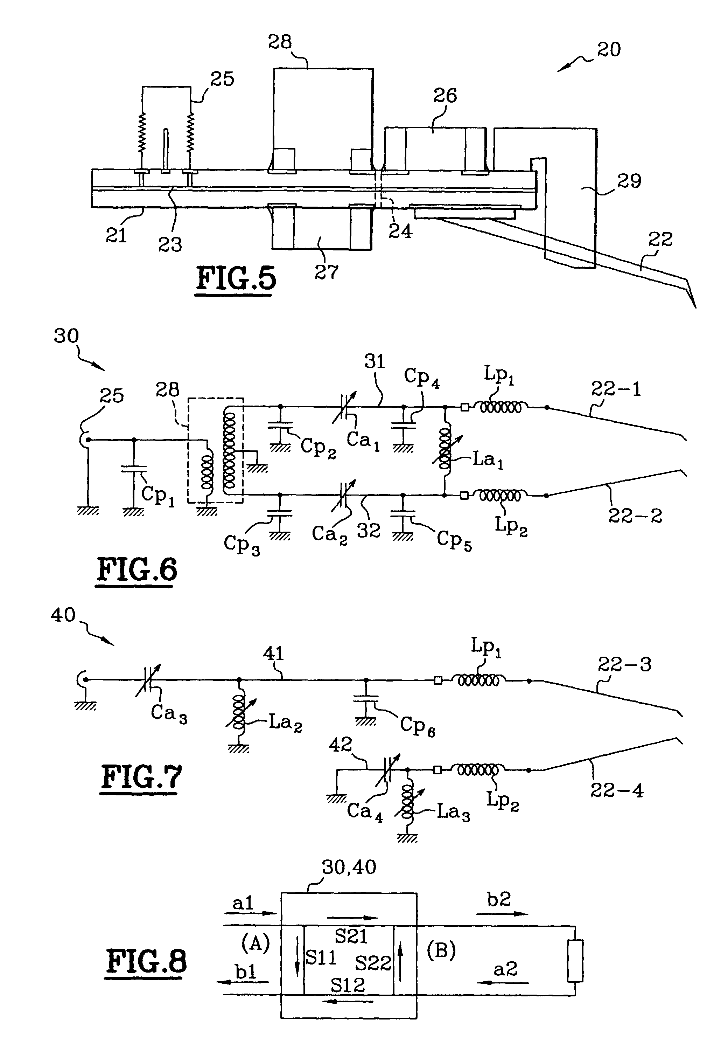

Comme illustré schématiquement par la vue en coupe de la figure 5, le circuit imprimé 21 est un circuit multicouche ayant de préférence un plan de masse 23 enterré et ininterrompu, des traversées métallisées 24 pour relier les divers niveaux conducteurs, et des connecteurs 25 de type RF. Les pointes 22, d'une faible longueur de l'ordre de 3 à 9 mm, sont soudées par leur base sur le circuit imprimé 21 et sont maintenues par une pièce électriquement isolante 29 formant une sorte de couronne s'étendant sous le circuit imprimé 21. Par ailleurs, le circuit imprimé 21 comporte sur ses deux faces des composants passifs 26, 27 comme des capacités et des inductances, permettant d'apparier les impédances des lignes de transmission de la sonde 20 reliant les connecteurs 25 aux pointes 22. Le circuit imprimé 21 comporte également des transformateurs 28, pour délivrer des signaux symétriques permettant de tester les entrées différentielles d'un circuit intégré.

Pour fixer les idées, la figure 6 représente le schéma électrique d'un mode de réalisation d'une ligne de transmission 30 prévue pour tester des entrées différentielles d'un circuit intégré ("balanced inputs"). La ligne 30 comprend deux pistes conductrices 31, 32 du circuit imprimé 21 conduisant à deux pointes 22-1, 22-2. Les pistes 31, 32 sont connectées aux bornes de la bobine secondaire d'un transformateur 28 dont le point milieu est connecté à la masse, la bobine primaire du transformateur étant reliée à un connecteur 25. Les pistes 31, 32 comportent chacune une capacité d'accord Ca1, Ca2 en série et sont reliées par une inductance d'accord La1. Les capacités Ca1, Ca2 et l'inductance La1 permettent de compenser l'influence d'éléments parasites présents dans la ligne de transmission 30, notamment une capacité parasite Cp1 présente entre le primaire du transformateur 27 et la masse, des capacités parasites Cp2, Cp3 présentes entre chaque borne du secondaire et la masse, des capacités parasites Cp4, Cp5 présentes entre chaque pointe 22-1, 22-2 et la masse, et les inductances parasites Lp1, Lp2 des pointes 22-1, 22-2. Plus particulièrement, les capacités d'accord Ca1, Ca2 et l'inductance La1 permettent de régler la fréquence de résonance de la ligne de transmission 30 de manière que la sonde 20 se comporte comme une "fenêtre transparente" permettant d'accéder à un circuit intégré.

De façon semblable, la figure 7 représente le schéma électrique d'un mode de réalisation d'une ligne de transmission 40 non symétrique prévue pour tester des entrées unipolaires d'un circuit intégré ("single-ended inputs"). La ligne de transmission 40 comprend une piste de phase 41 (signal) et une piste de masse 42 (référence) conduisant à des pointes 22-3, 22-4. Les pistes de phase 41 et de masse 42 sont pourvues chacune d'une capacité d'accord Ca3, Ca4 en série et sont connectées à la masse par une inductance La2, La3. Comme précédemment, ces composants permettent de compenser l'influence d'éléments parasites Lp1, Lp2, Cp6 présents dans la ligne de transmission.

On ne décrira pas plus en détail la sonde 20, dont la réalisation est en soi à la portée de l'homme de l'art et nécessite l'application de règles classiques dans le domaine des circuits haute fréquence. Le fait d'utiliser une sonde à circuit imprimé pour le test de circuits intégrés RF n'en demeure pas moins un aspect de la présente invention, qui se combine avec le procédé d'étalonnage décrit plus loin pour l'obtention d'un procédé de test simple à mettre en oeuvre et adapté à une production de masse.

**Réalisation de circuits étalons**

On va maintenant décrire des circuits étalons selon l'invention permettant d'étalonner la sonde 20 par la méthode OSL ("Open", "Short", "Load"). On rappelle préalablement en se référant à la figure 8 que les lignes de transmission RF de la sonde 20, par exemple les lignes 30 et 40 représentées sur les figures 6 et 7, peuvent être modélisées sous la forme d'un réseau RF à deux ports A, B comportant, vu du port A, un paramètre de réflexion S11 et un paramètre de transmission S21 et, vu du port B, un paramètre de réflexion S22 et un paramètre de transmission S12. En désignant par a1 une onde incidente envoyée sur le port A, par b1 l'onde renvoyée par le port A, par b2 l'onde transmise sur le port B et par a2 l'onde réfléchie par une charge Z à laquelle le port B est connecté, le réseau est défini par les relations suivantes :

$$(1) \qquad b1 = a1 \, S11 + a2 \, S12$$

$$(2) \qquad b2 = a1 \, S21 + a2 \, S22$$

Le réseau étant passif et linéaire, les coefficients S12 et S21 sont considérés comme égaux. Par ailleurs, la charge Z présente un coefficient de réflexion $\Gamma z$ obéissant à la relation classique :

$$(3) \qquad \Gamma z = a2/b2 = Z\text{-}Z0/Z\text{+}Z0$$

dans laquelle Z0 est l'impédance caractéristique de la ligne de transmission entre le réseau et la charge Z.

La combinaison des relations (1), (2) et (3) donne la relation suivante :

$$(4) \qquad \Gamma n = b1/a1 = (S11 + (S21^2 \, \Gamma z)/(1 - S22 \, \Gamma z))$$

dans laquelle $\Gamma n$ est le coefficient de réflexion du réseau vu du port A. La relation (4) comporte trois inconnues. En mesurant le coefficient de réflexion $\Gamma n$ depuis le port A avec trois charges étalon Z1, Z2, Z3 connectées au port B, notamment une charge infinie (circuit ouvert), une charge nulle (court-circuit) et une charge Z3 de valeur connue, la relation (4) permet de déterminer, pour une fréquence donnée, les paramètres S11, S21 et S22 du réseau. Ces paramètres sont des nombres complexes représentés par un terme réel et un terme imaginaire ou par une amplitude et une phase.

En pratique, les paramètres "S" de chacune des lignes de transmission RF de la sonde 20 vont être déterminés au moyen d'un analyseur de réseau, après trois mesures nécessitant de connecter successivement les pointes 22 à au moins trois charges étalons Z1, Z2, Z3. Le problème que pose l'étalonnage de la sonde 20, et de façon générale l'étalonnage d'une sonde RF prévue pour s'appliquer sur un circuit intégré, est essentiellement pratique et est lié au nombre important de lignes de transmission à étalonner, et au fait que de multiples réétalonnages sont nécessaires au cours du test électrique d'un lot de circuits intégrés.

Selon l'invention, on propose de réaliser des charges étalons sous la forme d'un circuit étalon sur substrat de silicium, reproduisant le schéma d'implantation des plages de connexion du circuit intégré à tester. Ce circuit étalon va permettre d'étalonner toutes les lignes de transmission RF de la sonde 20 avec un nombre de manipulations limité.

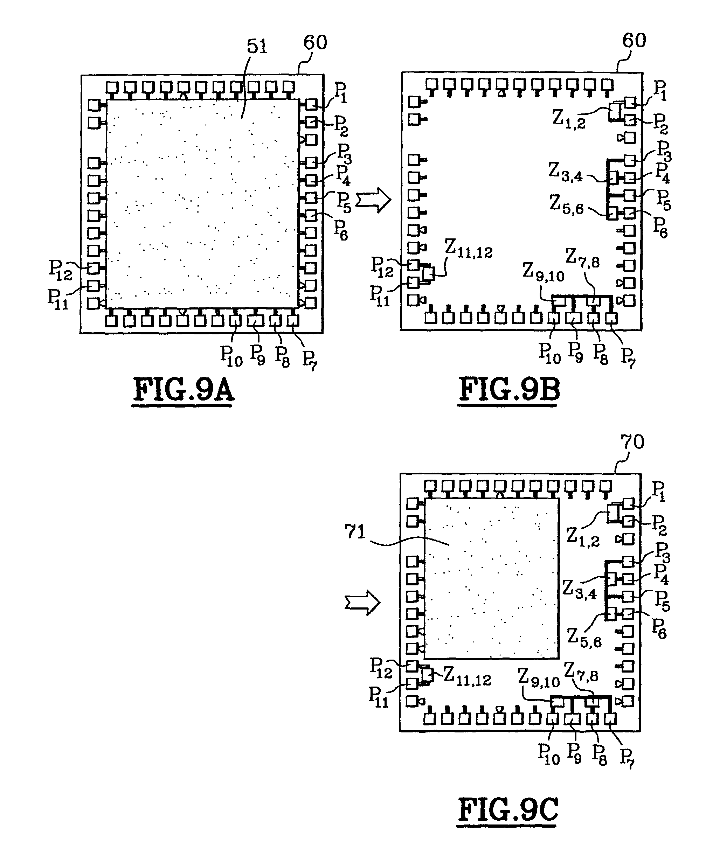

A titre d'exemple, la figure 9A représente un circuit intégré 50 comportant une zone active 51 et des plages de connexion en aluminium. Parmi ces plages de connexion, on distingue des plages de connexion P1, P2, P3... P12 correspondant à des entrées/sorties RF du circuit intégré. Ces entrées/sorties peuvent être de type unipolaire ("single-ended") ou de type différentiel ("balanced"). Les autres plages de connexion, non référencées sur la figure, sont des plages de connexion "non-RF" correspondant à des entrées-sorties basse fréquence (signaux logiques) ou à courant continu (tensions de biais, tensions d'alimentation, etc.).

La figure 9B représente un circuit étalon 60 selon l'invention, réalisé sur un substrat de silicium. Le circuit 60 est une sorte de circuit intégré 50 factice ne comportant pas la zone active 51, dans lequel on retrouve les plages de connexion RF et non-RF du circuit intégré 50. Les plages de connexion P1 à P12, correspondant aux plages RF de même référence du circuit 50, sont connectées deux par deux à une charge étalon élémentaire, respectivement $Z_{1,2}$, $Z_{3,4}$, $Z_{5,6}$, $Z_{7,8}$, $Z_{9,10}$, $Z_{11,12}$. Les plages non-RF demeurent sans connexion. Chaque paire de plages P1/P2, P3/P4,... P11/P12 forme ainsi, avec la charge étalon Z qui lui est associée, une structure étalon élémentaire sur substrat de silicium dont des exemples de réalisation seront décrits plus loin.

La figure 9C représente une variante de réalisation dans laquelle le circuit étalon, référencé 70, comporte en outre une zone active 71 connectée aux plages non-RF. La zone active 71 est une mémoire de type rémanent, par exemple une mémoire EEPROM comprenant des transistors à grille flottante, permettant de stocker les valeurs des charges étalons élémentaires Z présentes aux bornes des plages RF P1 à P12.

Selon l'invention, on réalise sur un wafer de silicium au moins trois circuits étalons 60 se différenciant par l'impédance caractéristique des charges étalons Z qu'ils comportent. Le premier circuit étalon, de type "O" ("Open"), comporte des plages RF non connectées, les charges Z étant alors des impédances présumées infinies. Le second circuit étalon, de type "S" ("Short"), comporte des plages RF mises en court-circuit deux par deux au moyen de pistes métalliques, les charges Z étant des résistances de valeur nulle. Le troisième circuit étalon, de type "L" ("Load"), comporte des plages RF reliées deux à deux par une résistance. De préférence, on prévoit également des circuits étalons de type "C1" et de type "C2", dans lesquels les charges Z sont des capacités ou des inductances. Ces circuits étalons complémentaires, optionnels, permettront de vérifier des résultats d'étalonnage comme on le verra plus loin.

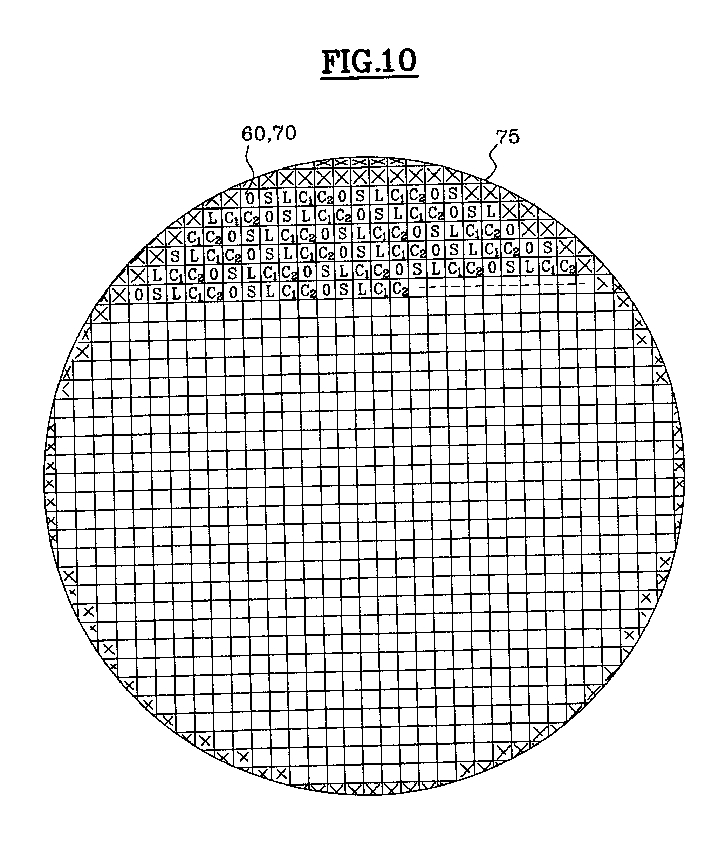

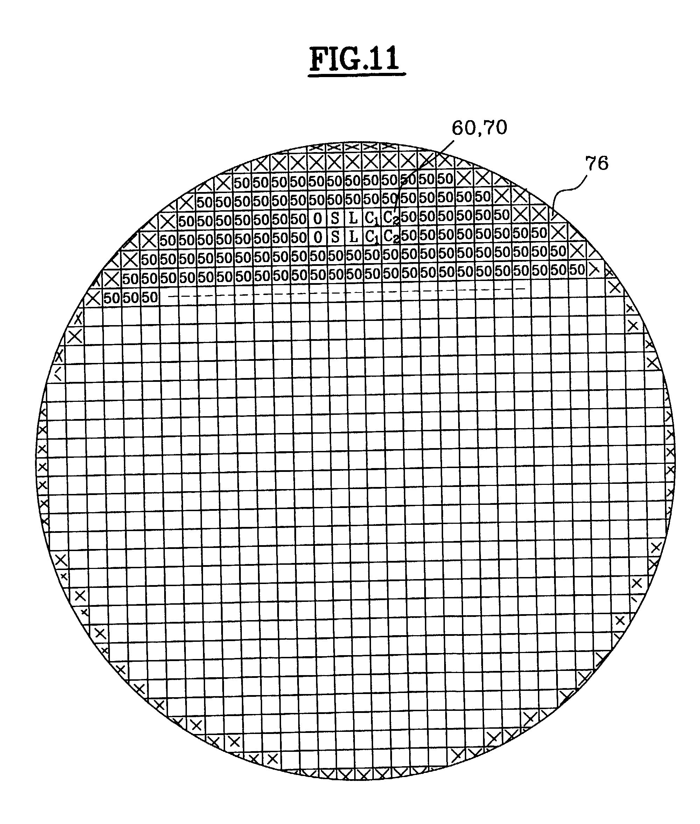

Les figures 10 et 11 illustrent deux modes de réalisation d'un wafer selon l'invention. Sur la figure 10, le wafer 75 ne comporte que des circuits étalons 60 ou 70 de type "O", "S", "L", "C1" et "C2" se succédant les uns aux autres et occupant toute la surface utile du wafer. Sur la figure 11, le wafer 76 est un wafer "production" comportant des circuits intégrés 50 destinés à être testés et commercialisés, ainsi que quelques circuits étalons 60 ou 70 agencés en lieu et place de certains circuits intégrés 50. Dans l'exemple représenté, le wafer 76 comporte deux rangées de cinq circuit étalons de type "O", "S", "L" "C1" et "C2, prenant la place de dix circuits intégrés 50.

Grâce à l'invention, on dispose ainsi de circuits étalons 60 ou 70 (figures 9B, 9C) de même forme et de même taille que les circuits intégrés 50 à tester (figure 9A), agencés sur un wafer 75 de même épaisseur que le wafer "production" (figure 10) ou sur le wafer "production" 76 lui-même (figure 11). Ces circuits étalons comportent des structures étalons élémentaires ayant des plages de contact coïncidant avec les pointes de la sonde 20 (figure 4), dédiée au test électrique des circuits intégrés 50. Comme on va le voir ci-après, ces structures étalons élémentaires vont servir "d'étalons de transfert" ("transfer standards") pour amener sur les lieux de production, où le test électrique des circuits intégrés est réalisé, une référence d'étalonnage donnée par des circuits couches minces sur céramique calibrés par un laboratoire national de métrologie.

**Mise en oeuvre d'un procédé d'étalonnage consistant en un "transfert d'étalons" sur les lieux de production**

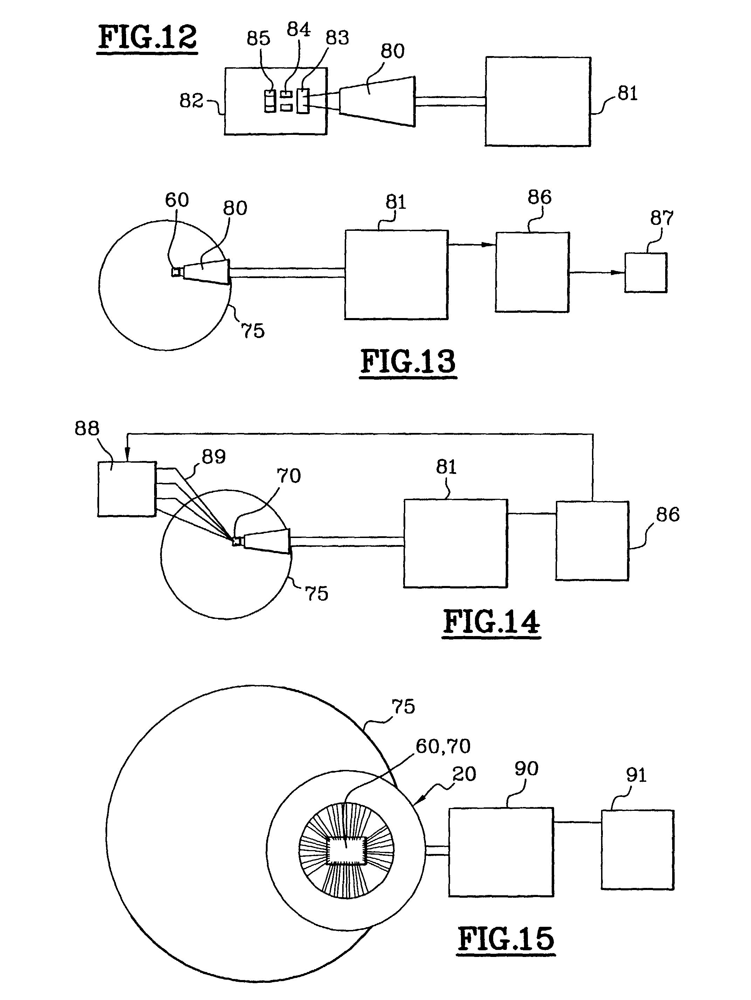

Au cours d'une première étape représentée schématiquement sur la figure 12, on étalonne deux pointes RF 80 au moyen d'un banc de mesure 81 et d'un circuit 82 à couches minces comportant des structures étalons 83, 84, 85 de type "O", "S", "L" calibrées par un laboratoire agréé. Les pointes 80 sont par exemple des pointes Cascade™ Microtech de la série "Air Coplanar". Le banc de mesure 81 est pourvu d'un analyseur de réseau classique, couramment disponible dans le commerce. Les paramètres "S" mesurés par l'analyseur de réseau sont utilisés pour calibrer le système de mesure jusqu'au bout des pointes 80.

Au cours d'une étape de calibrage des circuits étalons selon l'invention, représentée schématiquement sur la figure 13, on dispose le wafer 75 (fig. 10) sur le plateau de travail et l'on mesure au moyen des pointes RF 80 les caractéristiques électriques de chaque structure étalon élémentaire de chaque circuit étalon 60 présent sur le wafer. La mesure est effectuée à plusieurs fréquences, par exemple cinq fréquences, choisies en fonction de la fréquence nominale F0 des circuits intégrés devant être testés ultérieurement. Par exemple, on choisit des fréquences de 780, 790, 800, 810 et 820 MHz pour des circuits intégrés ayant une fréquence nominale de 800 MHz. Le banc de mesure 81 délivre les résultats des mesures à un ordinateur 86. Ces résultats sont enregistrée sur un support 87, par exemple une disquette, qui accompagnera ultérieurement le wafer 75 sur un site de production. Les mesures sont présentées sous la forme de N fichiers du type décrit par le tableau ci-après, chaque fichier donnant le coefficient de réflexion et la phase d'une charge étalon élémentaire $Z_{1,2}....Z_{11,12}$ d'un circuit étalon de type "O", "S", "L", "C1", ou "C2". Les fichiers peuvent être enregistrés sous le format "S1P", connu de l'homme de l'art.

La figure 14 illustre schématiquement une variante de l'étape de calibrage dans laquelle les circuits étalons 70 présents sur le wafer 75 comportent chacun une mémoire rémanente 71, comme décrit plus haut en relation avec la figure 9C. Dans ce cas, les fichiers contenant les valeurs des charges étalons élémentaires $Z_{1,2}....Z_{11,12}$ sont stockés dans la mémoire 71 au lieu d'être enregistrés sur une disquette. La programmation de la mémoire est faite de façon en soi classique, au moyen d'un programmeur 88 recevant les valeurs à enregistrer de l'ordinateur 86. Le programmeur 88 est connecté aux plages de contact non-RF du circuit 70 au moyen de pointes 89.

Tableau :

| exemples de fichiers : | | | | |
|---|---|---|---|---|
| Circuit | Type | Fichier | Fréquence de mesure | Mesures |
| Circuit étalon N° 1 | "O" ("open") | Fichier de $Z_{1,2}$ | F0 | $\Gamma = 0.95 \ \varphi = -15°$ |
| | | | F0+10MHz | $\Gamma = 0.94 \ \varphi = -16°$ |
| | | | F0-10MHz | $\Gamma = 0.96 \ \varphi = -14°$ |
| | | | F0+20MHz | $\Gamma = 0.93 \ \varphi = -17°$ |
| | | | F0-20MHz | $\Gamma = 0.97 \ \varphi = -13°$ |
| | | Fichier de $Z_{3,4}$ | F0 | $\Gamma = 0.95 \ \varphi = -15°$ |
| | | | F0+10MHz | $\Gamma = 0.95 \ \varphi = -16°$ |
| | | | F0-10MHz | $\Gamma = 0.95 \ \varphi = -14°$ |
| | | | F0+20MHz | $\Gamma = 0.95 \ \varphi = -17°$ |
| | | | F0-20MHz | $\Gamma = 0.96 \ \varphi = -13°$ |
| | | | | |
| | | Fichier de $Z_{11,12}$ | F0 | $\Gamma = 0.95 \ \varphi = -15°$ |
| | | | F0+10MHz | $\Gamma = 0.95 \ \varphi = -16°$ |
| | | | F0-10MHz | $\Gamma = 0.95 \ \varphi = -14°$ |
| | | | F0+20MHz | $\Gamma = 0.94 \ \varphi = -17°$ |
| | | | F0-20MHz | $\Gamma = 0.96 \ \varphi = -14°$ |
| Circuit étalon N° 2 | "S" ("short") | Fichier de $Z_{1,2}$ | F0 | $\Gamma = 0.98 \ \varphi = +20°$ |
| | | | F0+10MHz | $\Gamma = 0.97 \ \varphi = +25°$ |
| | | ... | ... | ... |
| | | Fichier de $Z_{3,4}$ | ... | ... |
| | | ... | ... | ... |
| | | Fichier de $Z_{11,12}$ | ... | ... |
| Circuit étalon N° 3 ...(etc.) | "L" ("Load") ... | Fichier de $Z_{1,2}$ | F0 | $\Gamma = 0.02 \ \varphi = +21°$ |
| | | ... | | |
| | | ... | ... | ... |
| | | ... | ... | ... |

L'étape de calibrage étant terminée, le wafer étalon 75 est envoyé sur un site de production, qui peut se situer à des milliers de kilomètres du lieu où il a été calibré. Sur le site de production, comme représenté schématiquement sur la figure 15, on dispose d'une station de test RF 90 connectée à un ordinateur 91, et de la sonde 20 déjà décrite. La sonde 20 est connectée aux ports RF et non-RF de la station 90 par des câbles coaxiaux ou autres types de câbles. Les câbles connectés aux ports RF sont préalablement étalonnés par la méthode OSL au moyen de charges standards disponibles dans le commerce. On procède à l'étalonnage de la sonde 20 au moyen de trois circuits étalons 60, 70 de type "O", "S" et "L" choisis sur le wafer 75 parmi l'ensemble des circuits étalons disponibles. De préférence, les circuits étalons ne sont utilisés qu'un nombre de fois déterminé, pour des raisons tenant à la dégradation des plages de contact par les pointes de test et la recherche d'un contact électrique optimal. Par ailleurs, selon que les circuits étalons 60, 70 présents sur le wafer 75 comportent ou non une mémoire intégrée 71, les valeurs des impédances étalons élémentaires $Z_{1,2}$, $Z_{3,4}...Z_{11,12}$ sont données par la disquette 87 (figure 13) ou sont lues directement dans la mémoire intégrée 71, au moyen de la sonde 20. Bien entendu, au lieu d'une disquette, les données peuvent aussi être transmises par l'intermédiaire d'un réseau informatique.

Ainsi, la sonde 20 est appliquée successivement sur trois circuits étalons, et la station 90 mesure les coefficients de réflexion Γn des diverses lignes de transmission RF de la sonde. Au terme des trois étapes, l'analyseur de réseau de la station 90 est en mesure de déterminer les paramètres "S" des lignes de transmission RF de la sonde. Ces paramètres sont conservés en mémoire comme paramètres correcteurs des mesures effectuées ultérieurement au cours du test électrique des circuit intégrés RF présents sur un wafer "production".

Le procédé d'étalonnage selon l'invention est simple et rapide à mettre en oeuvre. Il nécessite seulement l'installation du wafer 75 sur le plateau de test ("chuck") et le positionnement successif de la sonde 20 sur trois circuits étalons. Le procédé de l'invention peut être entièrement automatisé, et ne nécessite pas l'intervention d'un ingénieur qualifié RF.

Dans une variante du procédé de l'invention, on réalise l'étalonnage de la sonde au moyen des circuits étalons présents sur un wafer "production" 76 représenté sur la figure 11. Dans ce cas, les charges étalons élémentaires des circuits étalons peuvent être calibrées préalablement, selon la méthode illustrée par les figures 12 et 13, au moyen d'un banc de mesure installé dans les salles de production des plaquettes de silicium. Une autre solution, envisagée par la demanderesse, consiste à fournir à la station de test 90 des valeurs estimées des charges étalons élémentaires, déduites d'un grand nombre de mesures effectuées sur d'autres wafers. Cette méthode estimative, conduite avec rigueur, est à même de simplifier encore plus l'étalonnage des sondes de circuits intégrés RF.

Par ailleurs, avant de retirer le wafer 75, les circuits étalons complémentaires de type "C1" et "C2" permettent de vérifier le bon étalonnage de la sonde et de déceler une erreur isolée. Si les valeurs des impédances des circuits "C1" et "C2" mesurées avec la sonde 20 ne correspondent pas aux valeurs données par le banc de mesure de référence (figure 13 ou 14), on peut générer un signal d'alarme pour faire intervenir un opérateur. L'opérateur va procéder à un nettoyage de la sonde ou à un nouvel étalonnage.

## Réalisation de structures étalons élémentaires à faibles pertes

On va maintenant décrire un aspect de l'invention se rapportant aux structures étalons élémentaires présentes dans les circuits étalons de type "O", "S", "L", et "C1" ou "C2". Le silicium, en raison de ses propriétés de semi-conducteur, est réputé inapproprié à la réalisation de charges étalons. C'est pourquoi les charges étalons conventionnelles ont été jusqu'à présent réalisées en couches minces sur des substrats en céramique. Toutefois, grâce au procédé de l'invention décrit plus haut, qui permet de réaliser un "transfert d'étalons", on ne cherche pas ici à obtenir des impédances étalons de grande qualité se comportant comme des résistances pures. On cherche simplement à réaliser des impédances étalons dont les valeurs mesurables sont stables dans le temps, peu sensible à l'environnement et notamment aux divers parasites électriques pouvant remonter depuis le plateau de mesure. On cherche également à réaliser des étalons à faibles pertes RF, et à faible capacité répartie ("stray capacitance").

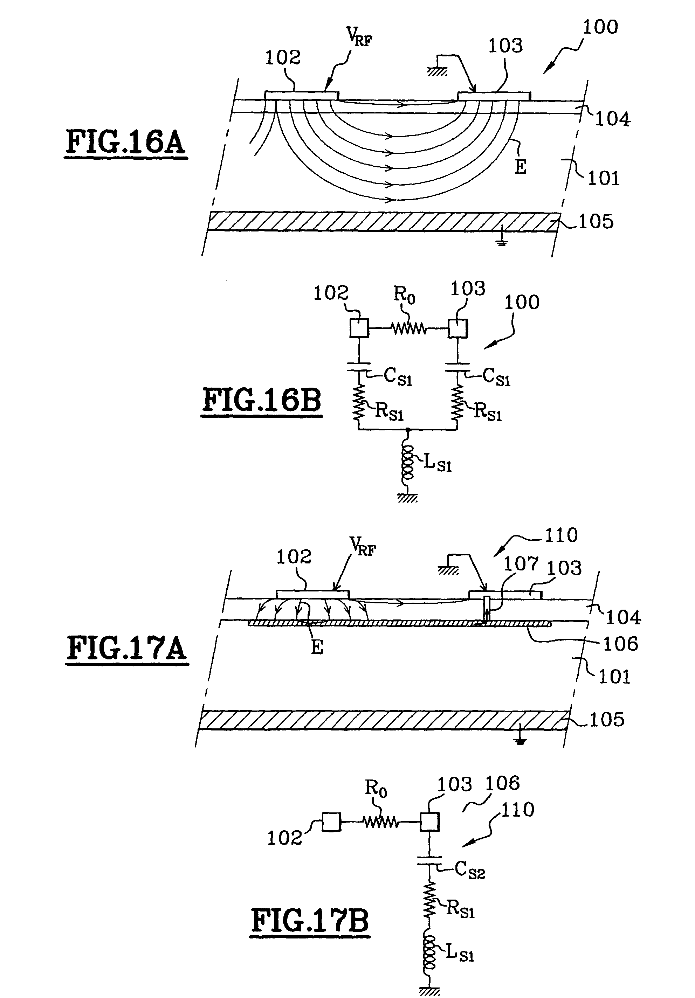

Pour fixer les idées, la figure 16A représente par une vue en coupe une structure étalon élémentaire 100 de type "O" (circuit ouvert) réalisée sur un substrat de silicium 101, notamment un wafer de silicium. La structure 100 comprend deux plages de contact 102, 103 déposées sur le substrat 101 par l'intermédiaire d'une couche électriquement isolante 104, par exemple en oxyde de silicium. On suppose ici que le substrat est posé sur un plateau métallique 105 connecté à la terre. L'application d'une tension VRF entre la plage 102 et la plage 103 fait apparaître un champ électrique E qui rayonne dans l'épaisseur du substrat 101 et fait que la structure étalon présente des pertes électriques. En outre, le schéma électrique équivalent de la figure 16B montre que les plages 102, 103, entre lesquelles se trouve une résistance R0 représentant le circuit ouvert, sont connectées à la terre par l'intermédiaire d'un circuit C,R,L comprenant une capacité parasite Cs1, la résistance électrique Rs1 du substrat et une inductance de fuite Ls1 du plateau métallique 105 relié à l'équipement de test. La capacité Cs1 est de forte valeur car ses armatures sont formées par toute la surface du substrat, qui s'étend bien au-delà de la structure étalon. Ainsi, si la masse de l'appareillage délivrant la tension $V_{RF}$ n'est pas isolée de la terre, comme c'est généralement le cas, on voit apparaître une boucle de terre favorisant la remontée de parasites électriques dans la structure étalon 100. La structure étalon 100 qui vient d'être décrite n'est donc pas entièrement satisfaisante. Il en irait de même si les plages 102, 103 étaient reliées par un court-circuit ou une résistance.

La figure 17A est une vue en coupe d'une structure étalon 110 selon l'invention, qui se distingue de la précédente par le fait qu'un écran conducteur 106 est enterré sous la couche d'oxyde 104. L'écran 106, en métal, silicium polycristallin ou silicium fortement dopé est connecté à la plage 104 (masse) par un orifice conducteur 107 traversant la couche d'oxyde, rempli de métal ou de silicium fortement dopé. L'écran 106 s'étend sur une aire limitée au regard de la surface du substrat mais sous-tend toutefois toute l'aire occupée par la structure étalon, de manière que les plages de contact 102, 103 surplombent l'écran 106. Ainsi, le champ électrique E est confiné entre la plage 102 et l'écran 106 et les pertes électriques sont diminuées. En outre, le schéma électrique équivalent de la figure 17B montre que la plage 102 est isolée du substrat 101 et du plateau métallique 105. La plage 103 demeure connectée à la terre par l'intermédiaire d'une capacité Cs2, de la résistance Rs1 et de l'inductance Ls1 du plateau métallique 105. Toutefois, la capacité Cs2 est beaucoup plus faible que la capacité Cs1 de la figure 16B car ses armatures sont définies par la taille de l'écran 106, qui est très inférieure à celle du substrat. La structure étalon 110 est donc plus satisfaisante que la structure 100. On décrira plus loin des structures étalons de type différentiel, dans lesquelles l'écran conducteur forme une masse virtuelle. Ces structures sont considérées par les inventeurs comme entièrement satisfaisantes et entièrement protégées contre les influences parasites. De façon générale, il est important que l'écran conducteur 106 soit à un potentiel RF "froid" ("RF cold"). En d'autres termes, l'écran ne doit pas recevoir la phase du signal de mesure et doit être connecté à la plage de masse, ou former une masse virtuelle.

On va maintenant décrire des exemples de structures étalons élémentaires comportant d'autres caractéristiques selon l'invention.

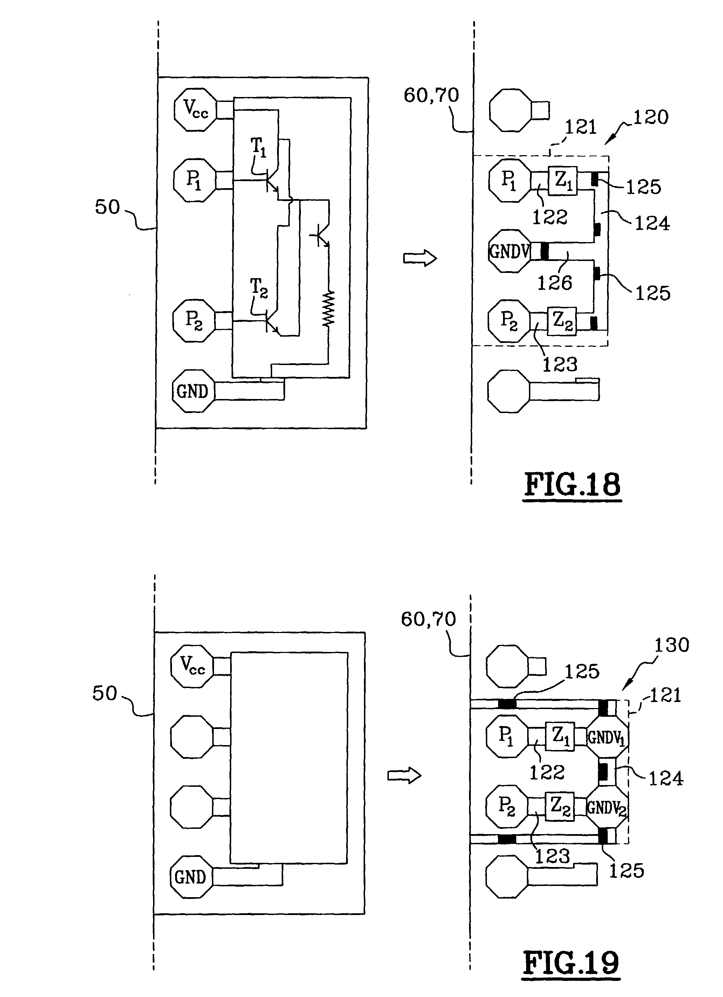

Les figures 18 et 19 représentent deux structures étalons élémentaires 120, 130 (partie droite des figures) et l'arrangement initial des plages de connexion sur le circuit intégré 50 (partie gauche des figures). Ces structures étalons 120, 130 sont de type symétrique et destinées à l'étalonnage de lignes de transmission symétriques (figure 6), permettant de tester des entrées différentielles du circuit intégré. Au moment de l'étalonnage de la sonde, les structures 120, 130 vont ainsi recevoir un signal symétrique. Toutefois, les pointes RF de type "Air Coplanar" utilisées pour le calibrage des structures étalons (étape de la figure 13) ne peuvent effectuer de mesures en mode différentiel, pour des raisons inhérentes à leur structure HF. Les structures étalons 120, 130 résolvent cet inconvénient, comme on va le voir maintenant.

Sur la figure 18, partie gauche, le circuit intégré 50 comporte par exemple une plage d'alimentation Vcc, une plage de masse GND, et deux plages P1, P2 correspondant à une entrée différentielle, représentée schématiquement par un montage de deux transistors T1, T2 à émetteur commun. Sur la partie droite de la figure, la structure étalon élémentaire 120 comprend les deux plages P1, P2 et est délimitée par un écran conducteur 121 enterré sous une couche isolante, dont les bords sont matérialisés par des traits pointillés. Les plages P1, P2 sont connectées chacune à une charge Z1, Z2 par des tronçons de pistes conductrices 122, 123. Les charges Z1, Z2 sont représentées sous la forme d'un emplacement de forme carrée pouvant être laissé vide (circuit ouvert) ou recevoir une matière conductrice, par exemple un dépôt d'aluminium de forme particulière, large ou étroite (court-circuit ou résistance), ou une matière résistive comme du silicium dopé (résistance). A leurs autres extrémités, les charges Z1, Z2 sont connectées l'une à l'autre par un troisième tronçon de piste 124. Le tronçon de piste 124 est lui-même connecté à l'écran 106 par divers orifices conducteurs 125 traversant la couche isolante. Par ailleurs, le tronçon 124 se prolonge dans sa partie centrale sous la forme d'un bras 126 conduisant à une plage de masse virtuelle GNDV, agencée entre les plages P1, P2, dans l'alignement de ces dernières.

Ainsi, au cours de l'étape de mesure illustrée par la figure 13, on mesure tout d'abord la charge Z1 en plaçant les pointes (80) sur les plages P1 et GNDV. On mesure ensuite la charge Z2 par l'intermédiaire des plages P2 et GNDV. La charge étalon élémentaire pour l'étalonnage d'une ligne de transmission différentielle est calculée en faisant la somme des deux charges Z1 et Z2.

Il découle de qui précède qu'un circuit étalon selon l'invention peut comprendre des plages de mesure supplémentaires qui ne figurent pas dans le schéma initial du circuit intégré à tester. Ces plages n'ont pas été représentées sur les figures 9B et 9C dans un souci de simplicité.

La structure élémentaire 130 de la figure 19 se distingue de la structure 120 par le fait que deux plages de masse virtuelle GNDV1, GNDV2 sont agencées en regard des plages P1 et P2, de l'autre côté des charges Z1, Z2, les plages P1 et P2 étant trop proches l'une de l'autre pour permettre l'insertion d'une plage de mesure. Le tronçon de piste 124 relie les plages GNDV1, GNDV2 et se prolonge au-delà de ces dernières pour longer l'aire occupée par l'écran 121 et garantir une bonne connexion à ce dernier, grâce à divers orifices conducteurs 125. Ici, la charge Z1 est mesurée entre les plages P1 et GNDV1 et la charge Z2 est mesurée entre les plages P2 et GNDV2.

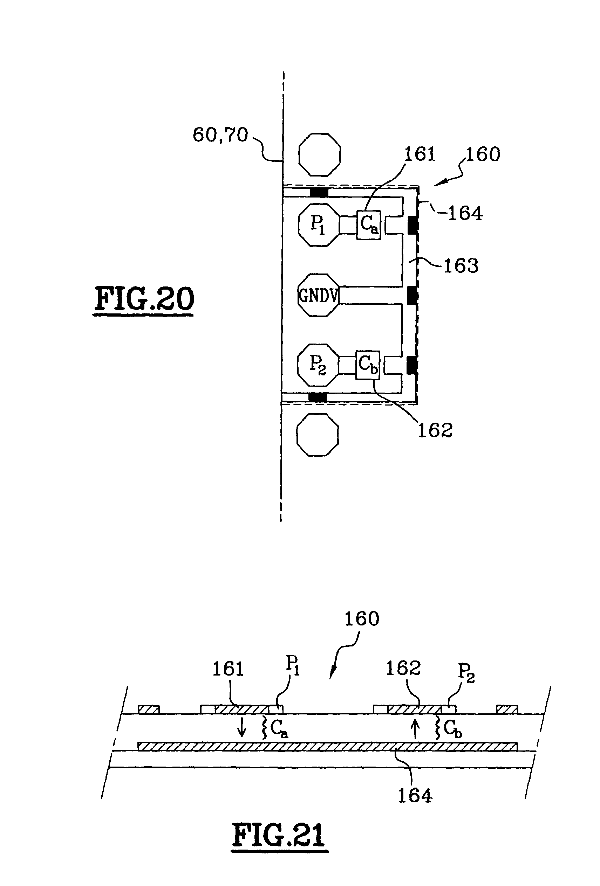

La figure 20 représente une structure étalon symétrique 160 de type "C1" ou "C2". Cette structure 160 ressemble fortement à une structure de type "S" qui serait réalisée conformément à la figure 18, les charges élémentaires étant formées par des carrés de matière conductrice, ou plaques 161, 162, connectées aux plages P1, P2. Toutefois, ici, les plaques 161, 162 ne viennent pas au contact du tronçon de piste central 163 (le tronçon de piste 163, connecté à l'écran enterré 164, est conservé car la structure 160 est réalisée de la même manière qu'une structure de type "O", "S" ou "L"). Ainsi, comme cela apparaît plus clairement sur la vue en coupe de la figure 21, les plaques 161, 162 forment avec l'écran conducteur enterré 164 deux condensateurs en série Ca, Cb. L'impédance totale de la structure 160 est un condensateur dont la valeur dépend de la dimension des plaques 161, 162.

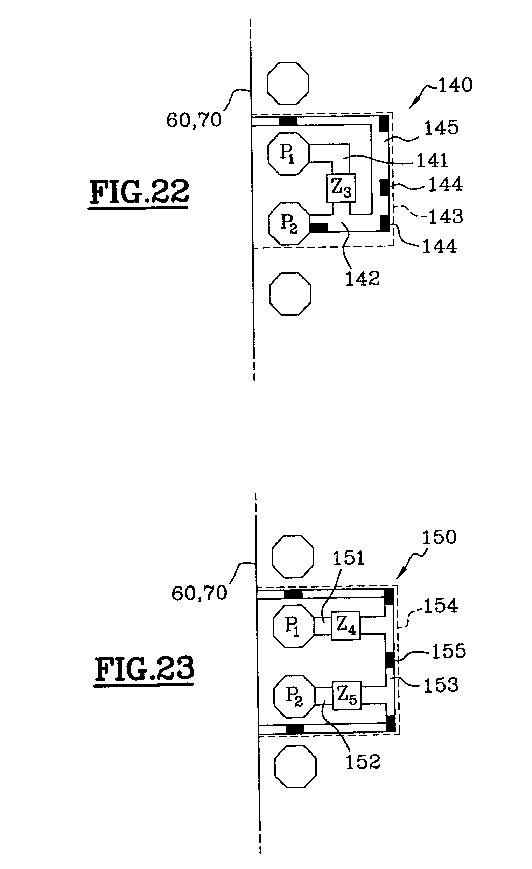

La figure 22 représente une structure étalon élémentaire 140 de type non symétrique, dans laquelle la plage P1 est destinée à recevoir la phase et la plage P2 à recevoir la masse d'un signal de mesure. La plage P1 est reliée à une charge Z3 par un tronçon de piste 141 et la plage P2 est reliée à l'autre extrémité de la charge Z3 par un tronçon de piste 142. Le tronçon de piste 142 est connecté à un écran conducteur enterré 143 par l'intermédiaire d'orifices conducteurs 144, agencés notamment le long d'un bras 145 longeant l'aire occupée par l'écran 143.

Enfin, la figure 23 représente une structure symétrique 150 dans laquelle la plage P1 est connectée par un tronçon de piste 151 à une charge Z4 et la plage P2 est connectée par un tronçon de piste 152 à une charge Z5. Un tronçon de piste 153 relie les charges Z4, Z5 dont la somme forme l'impédance étalon. Ici, seul le tronçon de piste 153 est connecté à un écran enterré 154, par des orifices conducteurs 155. L'écran 154 forme donc une masse virtuelle, bien que la structure ne comporte pas de plage de masse virtuelle.

Des structures étalon capacitives de type non symétrique peuvent également être réalisées en suivant l'enseignement de la figure 20, les charges Z3, ou Z4 et Z5 prenant alors la forme de plaque conductrices connectées uniquement aux plages P1, P2. De même, des structures inductives peuvent être réalisées au moyen de motifs métalliques en forme de bobines plates.

**Aspects technologiques des structures étalons selon l'invention**

En pratique, les structures étalons selon l'invention sont de préférence réalisées au moyen de la même technologie que le circuit intégré correspondant. Ainsi, par exemple, la technologie dite "HSB2" ("High Speed Bipolar") utilisée pour la fabrication de circuits intégrés RF permet de réaliser dans le substrat des sillons isolants, ou fossés ("trench"), atteignant des couches enterrées fortement dopées ou des couches de silicium épitaxiales. Dans ce cas, on réalise tout d'abord une couche conductrice recouvrant tout le substrat, par bombardement ionique ou épitaxie de silicium en présence d'un agent dopant. Après dépôt d'une ou plusieurs couches d'oxyde et réalisation des autres éléments, des sillons sont pratiqués tout autour de chaque structure étalon selon l'invention afin de découper la couche conductrice enterrée, et faire apparaître sous chaque structure élémentaire un écran conducteur isolé du reste de la couche conductrice. Un autre mode de réalisation, en soi plus conventionnel, consiste à graver la couche enterrée avant le dépôt de la couche d'oxyde, de manière à ne laisser subsister que les écrans conducteurs.

**Généralisation de l'emploi d'un écran conducteur**

Comme cela apparaîtra clairement à l'homme de l'art, il est avantageux qu'un circuit étalon selon l'invention ait des propriétés électriques qui se rapprochent le plus possible de celles du circuit intégré à tester. Ainsi, il entre dans le cadre de la présente invention de réaliser des circuits intégrés, par exemple le circuit 50 de la figure 9A, ayant sous chaque paire de plages RF un écran conducteur. La prévision d'un tel écran ne peut qu'améliorer les performances du circuit à haute fréquence, en réduisant ses pertes électriques. L'écran est agencé comme illustré par l'une des figures 18 à 23, selon que les plages du circuit intégré correspondent à des entrées/sorties symétriques ou non symétriques. L'écran peut être connecté à la plage de masse dans le cas d'une entrée non symétrique. Dans le cas d'une entrée différentielle, l'écran peut être connecté au point milieu de la charge vue depuis les plages de connexion. Ce point milieu est par exemple le point de connexion des émetteurs des transistors T1, T2 représentés sur la figure 18.

**Résumé et portée de l'invention**

On a décrit dans ce qui précède divers aspects de la présente invention concourrant à l'obtention d'un résultat commun, à savoir l'amélioration, la rationalisation et la simplification du test électrique des circuits intégrés RF. Le premier aspect de l'invention se rapporte à l'utilisation optionnelle d'une sonde RF réalisée à partir d'un circuit imprimé, en remplacement des sondes à membrane classiques. Le second aspect se rapporte à la réalisation de circuits étalons sur silicium ayant des plages de contact coïncidant avec les plages de connexion d'un circuit intégré à tester et, par conséquent, avec les pointes ou les boules de contact d'une sonde prévue pour tester le circuit intégré. Le troisième aspect de l'invention se rapporte à l'étalonnage d'une sonde de test au moyen de ces circuits étalons, utilisés en tant qu'étalons de transfert. Le quatrième aspect de l'invention se rapporte à la réalisation de structures étalons sur silicium à faibles pertes, comportant un écran enterré, et à la généralisation de l'écran enterré aux circuits intégrés RF eux-mêmes. Enfin, le cinquième aspect de l'invention se rapporte à des modes de réalisation de structures étalons élémentaires, notamment des structures symétriques comportant des plages de contact supplémentaires pour être calibrées avec des pointes RF non symétriques. Il apparaîtra clairement à l'homme de l'art que ces divers aspects de l'invention sont indépendants les uns des autres, bien que leur combinaison forme un tout avantageux permettant d'atteindre de la façon la plus directe l'objectif général de l'invention.

**Revendications**

**1.** Procédé d'étalonnage d'une sonde (20) de circuit intégré RF (50), comprenant une étape de détermination au moyen d'un analyseur de réseau (90) et de circuits étalons des caractéristiques des lignes de transmission RF (30, 40) de la sonde (20), caractérisé en ce que l'étape de détermination est réalisée au moyen de circuits étalons (60, 70) intégrés sur une plaquette de silicium (75, 76), les circuits étalons (60, 70) comprenant des plages de contact (P1-P12) correspondant par leur agencement à des plages de connexion RF (P1-P12) du circuit intégré à tester (50) et se différenciant entre eux par des impédances caractéristiques (O, S, L, C1, C2) différentes mesurables depuis leurs plages de contact.

**2.** Procédé selon la revendication 1, comprenant une étape préalable de mesure des valeurs des impédances caractéristiques de circuits étalons (60, 70) réalisée au moyen d'un matériel de mesure (80) préalablement étalonné au moyen de charges de référence (83, 84, 85) calibrées par un laboratoire agréé.

**3.** Procédé selon l'une des revendications 1 et 2, dans lequel les valeurs des impédances caractéristiques des circuits étalons (60, 70) sont fournies à l'analyseur de réseau (90) par l'intermédiaire d'un support d'enregistrement de données (87).

**4.** Procédé selon l'une des revendications 1 à 2, dans lequel les valeurs des impédances caractéristiques des circuits étalons sont lues dans des mémoires (71) de type rémanent agencées dans les circuits étalons (70) et accessibles en lecture ou en écriture par l'intermédiaire de plages de contact des circuits étalons (70) correspondant à des plages de connexion non-RF du circuit intégré à tester (50).

**5.** Procédé selon l'une des revendications 1 à 4, dans lequel l'étalonnage de la sonde (20) est réalisé au moyen d'un premier circuit étalon (60, 70, "O") comportant des plages de contact non connectées entre elles, d'un second circuit étalon (60, 70, "S") comportant des plages de contact en court-circuit, et d'un troisième circuit étalon (60, 70, "L") comportant des plages de contact reliées par des résistances électriques.

**6.** Procédé selon la revendication 5, dans lequel l'étalonnage de la sonde (20) est vérifié au moyen d'au moins un quatrième circuit étalon (60, 70, "C1", "C2") comportant des plages de contact reliées par des capacités ou des inductances.

**7.** Procédé selon l'une des revendications 1 à 6, dans lequel les circuits étalons (60, 70) comprennent également des plages de contact correspondant à des plages de connexion non-RF du circuit intégré à tester.

**8.** Procédé selon l'une des revendications 1 à 7, dans lequel la plaquette de silicium (75) ne comporte que des circuits étalons (60, 70).

**9.** Procédé selon l'une des revendications 1 à 7, dans lequel la plaquette de silicium comporte des circuits intégrés RF à tester (50) et des circuits étalons (60, 70) en lieu et place de certains circuits intégrés RF.

**10.** Procédé selon l'une des revendications 1 à 9, dans lequel les circuits étalons (60, 70) comprennent des structures étalons élémentaires (110, 120, 130, 140, 150, 160) comportant au moins deux plages de contact (P1, P2) déposées sur une couche électriquement isolante (104), un écran conducteur (106, 121, 164, 143, 154) enterré sous la couche isolante et les plages de contact surplombant l'écran conducteur.

**11.** Procédé selon la revendication 10, dans lequel les structures étalons élémentaires comprennent deux charges étalons en série (Z1, Z2, Z4, Z5, Ca, Cb) connectées par leur point milieu à l'écran conducteur, et au moins une plage de masse virtuelle (GNDV, GNDV1, GNDV2) pour la mesure des impédances de chaque charge étalon.

**12.** Procédé de test électrique d'un circuit intégré RF (50) présent sur une plaquette de silicium, réalisé au moyen d'une sonde RF (20) et d'une station de test (90) pourvue de ports RF et d'un analyseur de réseau, caractérisé en ce qu'il comprend une étape d'étalonnage de la sonde (20) selon le procédé de l'une des revendications 1 à 11, et en ce que les caractéristiques RF de la sonde (20) sont utilisées comme termes correctifs au cours du test électrique du circuit intégré.

**13.** Procédé selon la revendication 12, caractérisé en ce que la sonde (20) comprend une carte à circuit imprimé (21) pourvue de pointes de contact (22) de faible longueur.

**14.** Procédé selon la revendication 13, caractérisé en ce que des lignes de transmission RF (30, 40) de la sonde (20) comprennent des condensateurs (Ca1, Ca2) et des bobines (La1, La2) pour compenser au moins en partie l'influence de capacités et d'inductances parasites (Cp1-Cp6, Lp1, Lp2).

FIG.1

FIG.2

FIG.3

FIG.4

**FIG.5**

**FIG.6**

**FIG.7**

**FIG.8**

**FIG.9A**

**FIG.9B**

**FIG.9C**

# FIG.10

# FIG.11

FIG.12

FIG.13

FIG.14

FIG.15

**FIG.16A**

$V_{RF}$

102

103

100

104

E

101

105

**FIG.16B**

102 $R_0$ 103 100

$C_{S1}$ $C_{S1}$

$R_{S1}$ $R_{S1}$

$L_{S1}$

**FIG.17A**

102 $V_{RF}$

110

107 103

104

106

101

E

105

**FIG.17B**

$R_0$ 103 106

102 110

$C_{S2}$

$R_{S1}$

$L_{S1}$

## FIG.18

## FIG.19

60,70

161    160

P₁    Cₐ    164

163

GNDV

P₂    Cᵦ

162

<u>FIG.20</u>

160

161    P₁    162    P₂

Cₐ    Cᵦ

164

<u>FIG.21</u>

EP 1 030 182 A1

## FIG.22

## FIG.23

Office européen
des brevets
**RAPPORT DE RECHERCHE EUROPEENNE**

Numéro de la demande
EP 00 43 0006

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 445 928 A (CASCADE)<br>11 septembre 1991 (1991-09-11)<br>voir résumé<br>--- | 1 | G01R1/067 |
| A | US 5 748 006 A (SANO)<br>5 mai 1998 (1998-05-05)<br>voir résumé<br>--- | 10 | |
| A | BUCK ET AL.: "the development of an ate system"<br>CONF. PROC. 14TH EURONEAN MICROWAVE CONFERENCE 84, 10 – 13 septembre 1984, pages 462-467, XP002121347<br>Liège, be<br>* figure 1 *<br>---- | 12 | |
| | | | **DOMAINES TECHNIQUES RECHERCHES (Int.Cl.7)**<br><br>G01R |

Le présent rapport a été établi pour toutes les revendications

| Lieu de la recherche | Date d'achèvement de la recherche | Examinateur |
|---|---|---|
| LA HAYE | 4 avril 2000 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 00 43 0006

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-04-2000

| Document brevet cité au rapport de recherche | Date de publication | Membre(s) de la famille de brevet(s) | | Date de publication |
|---|---|---|---|---|
| EP 445928 A | 11-09-1991 | US | 4994737 A | 19-02-1991 |
| | | JP | 4219945 A | 11-08-1992 |
| US 5748006 A | 05-05-1998 | JP | 8136582 A | 31-05-1996 |

EPO FORM P0460

Pour tout renseignement concernant cette annexe : voir Journal Officiel de l'Office européen des brevets, No.12/82